Europäisches Patentamt

European Patent Office

Office européen des brevets

(19)

(11) EP 1 111 797 A1

## (12) EUROPEAN PATENT APPLICATION
published in accordance with Art. 158(3) EPC

(43) Date of publication:
27.06.2001  Bulletin 2001/26

(21) Application number: 00917397.2

(22) Date of filing: 21.04.2000

(51) Int Cl.⁷: $H03M\ 13/00$

(86) International application number:
PCT/JP00/02604

(87) International publication number:
WO 00/77937 (21.12.2000 Gazette 2000/51)

(84) Designated Contracting States:
AT BE CH CY DE DK ES FI FR GB GR IE IT LI LU
MC NL PT SE

(30) Priority: 10.06.1999  JP 16405599

(71) Applicant: MATSUSHITA ELECTRIC INDUSTRIAL
CO., LTD.
Kadoma-shi, Osaka 571-8501 (JP)

(72) Inventors:
• KAJITA, Kuniyuki
  Yokosuka-shi, Kanagawa 239-0847 (JP)
• TODA, Takashi
  Ishikawa-gun, Ishikawa 921-8824 (JP)

(74) Representative: Grünecker, Kinkeldey,
Stockmair & Schwanhäusser Anwaltssozietät
Maximilianstrasse 58
80538 München (DE)

## (54) INTERLEAVE DEVICE AND INTERLEAVE METHOD

(57)  Input memory 101 stores input data. Row pattern memory 102 stores row patterns. Column pattern memory 103 stores column patterns. Output memory 104 stores output data with the sequence of the input data rearranged. Address calculation apparatus 105 calculates addresses of the input data to be written to the output data and further writes input data read from input memory 101 in output memory 104 as output data based on the calculated input addresses.

FIG.3

EP 1 111 797 A1

**Description**

Technical Field

The present invention relates to a coding/decoding processing apparatus and a coding/decoding processing method in a CDMA (Code Division Multiple Access) mobile communication.

Background Art

In order to avoid deterioration of communication quality due to burst errors on transmission paths, conventional CDMA-based communication systems use interleave that can convert burst errors to random errors by rearranging the sequence of transmission data. Interleave (hereinafter referred to as "IL") is a technique by which an apparatus on the transmitting side transmits transmission data whose sequence has been rearranged according to a predetermined pattern and an apparatus on the receiving side restores the original sequence of the received data. This makes it possible to convert burst errors that occur on a transmission path to random errors and carry out higher-level error correction decoding.

IL processing by the apparatus on the transmitting side is carried out using the procedure described below. Here, a case where IL processing is carried out on L data items will be explained as an example. That is, firstly an $M \times N$ matrix is created by repeating M times processing of writing N of L data items sequentially in the horizontal direction. Then, repeating N times processing of reading M data items sequentially from the matrix created in this way in the vertical direction produces L data items whose data sequence has been rearranged. This IL processing is generally expressed as $L[M \times N]$.

In a communication system according to a next-generation mobile communication system, whose service will start from 2001, that is, a W-CDMA-based communication system, Multistage Interleave (MIL) is used as interleave. MIL is a newly proposed technique to assist higher-level error correction decoding instead of IL and used to repeat IL processing in a hierarchical fashion according to the MIL system specified for every channel that carries out communication. Hereinafter, MIL processing used in a conventional CDMA communication system will be explained. Here, a MIL expression that is expressed in the following expression will be explained as an example.

$$20[5[3 \times 2] \times 4[2 \times 2]] \qquad \qquad -(1)$$

Expression (1) indicates that 20 input data items In[x] (x=0 to 19) (e,g., 20 data items each having address {0,1, 2, ..., 18, 19}) are developed into a $5 \times 4$ matrix, then IL processing of $4[2 \times 2]$ is carried out on every row and IL processing of $5[3 \times 2]$ is carried out on every column. Performing such processing develops expression (1) and produces 20 output data items Out[y] (y=0 to 19) whose sequence has been rearranged. That is, input data is written to output data sequentially according to the address shown in the following expression:

$$\{0,8,16,4,12,2,10,18,6,14,1,9,17,5,13,3,11,19,7,15\} \qquad \qquad -(2)$$

Each number in expression (2) denotes an address.

Here, the MIL expression expressed in a form like $5[3 \times 2]$ and $4[2 \times 2]$ is referred to as "MIL expression of stage 1" and the MIL expression expressed in a form like $20[5[3 \times 2] \times 4[2 \times 2]]$ is referred to as "MIL expression of stage 2".

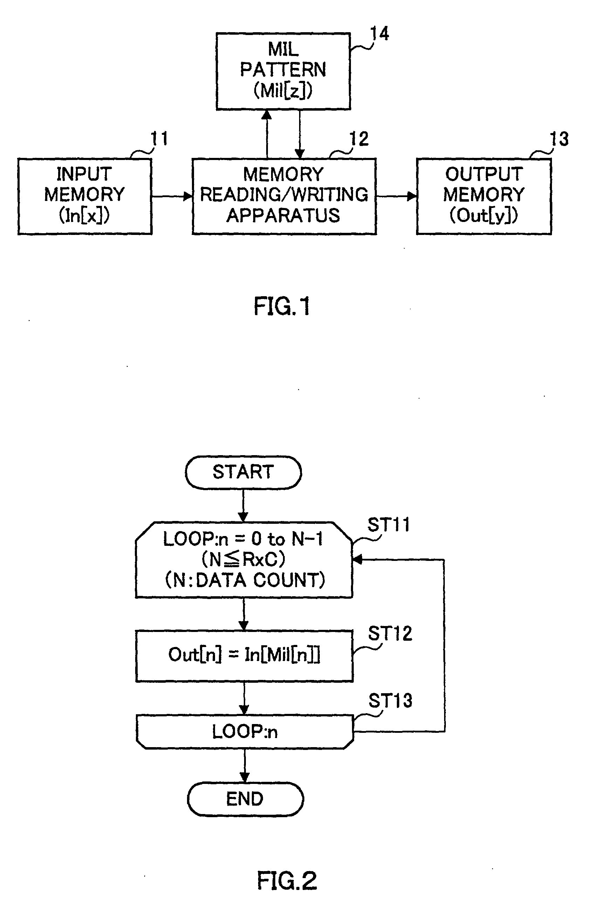

Since IL processing needs to be carried out repeatedly in the MIL processing above, using a MIL expression of a deeper stage requires longer processing time. Thus, in the conventional CDMA system, MIL processing is carried out using the MIL apparatus shown in FIG.1 to reduce processing time.

FIG.1 is a block diagram showing a configuration of a conventional MIL apparatus. As shown in FIG.1, the conventional MIL apparatus is configured by input memory 11, memory reading/writing apparatus 12, output memory 13 and MIL pattern memory 14 that stores MIL patterns.

In the MIL apparatus shown in FIG.1, MIL pattern memory 14 stores a MIL pattern of stage 0 created from the MIL expression and memory reading/writing apparatus 12 performs indirect addressing on the stored MIL pattern, and thereby the sequence of transmission data can be rearranged. Here, the operation of the MIL apparatus shown in FIG.1 will be explained below by taking a case where the MIL expression shown in expression (1) is used as an example.

As described above, developing the MIL expression shown in expression (1) produces a MIL pattern shown in expression (2). This MIL pattern is stored in MIL pattern memory 14 in FIG.1. Furthermore, 20 input data items In[x] (x=0 to 19) (e.g., 20 data items each having address {0,1, 2, ..., 18, 19}) are stored in input memory 11. Suppose the data items stored in input memory 11, output memory 13 and MIL pattern memory 14 are In[x], Out[y] and Mil [z] (x, y, z=0 to 19 ) , respectively. Then, MIL processing is carried out according to an operation flow shown in FIG.2.

FIG.2 is a flow chart showing the operation of the conventional MIL apparatus. As shown in FIG.2, memory reading/writing apparatus 12 accesses memory 11 sequentially according to the addresses shown in expression (2) and writes the accessed data in output memory 13, and thereby the output data whose sequence of the input data stored in input memory 11 is rearranged is written in output memory 13. According to such MIL processing, the processing time is not affected by the depth of stage of the MIL expression used, and therefore the processing time is shortened.

However, MIL pattern memory 14 of the conventional MIL apparatus above stores data equivalent in size to the input data to be subjected to MIL processing. Accordingly the conventional MIL apparatus involves a problem that as the amount of input data (number of bits) increases, the amount of memory required grows a great deal.

Disclosure of Invention

It is an object of the present invention to provide an interleave apparatus that reduces the amount of memory required.

This object is attained by creating at least one MIL pattern (sequence conversion series) using at least one element included in a MIL expression (sequence conversion rule expression) stipulated or specified for every input data item and changing the sequence of the input data using the created MIL pattern.

Brief Description of Drawings

FIG.1 is a block diagram showing a configuration of a conventional MIL apparatus;

FIG.2 is a flow chart showing operation of the conventional MIL apparatus;

FIG.3 is a block diagram showing a configuration of a MIL apparatus according to Embodiment 1 of the present invention;

FIG.4 is a flow chart showing processing of writing to an output memory by an address calculation apparatus in the MIL apparatus according to Embodiment 1 of the present invention;

FIG.5 illustrates an amount of memory required of the MIL apparatus according to Embodiment 1 above compared to the conventional system;

FIG.6 is a flow chart showing processing of writing to the output memory by an address calculation apparatus in the MIL apparatus according to Embodiment 2 of the present invention;

FIG.7 is a flow chart showing processing of writing to the output memory by an address calculation apparatus in a MIL apparatus according to Embodiment 3 of the present invention;

FIG.8 is a flow chart showing processing of writing to the output memory by an address calculation apparatus in a MIL apparatus according to Embodiment 4 of the present invention;

FIG.9 is a flow chart showing processing of writing to the output memory by an address calculation apparatus in a De-MIL apparatus according to Embodiment 5 of the present invention;

FIG. 10 is a flow chart showing processing of writing to the output memory by an address calculation apparatus in a De-MIL apparatus according to Embodiment 6 of the present invention;

FIG. 11 is a flow chart showing processing of writing to the output memory by an address calculation apparatus in a De-MIL apparatus according to Embodiment 7 of the present invention;

FIG.12 is a flow chart showing processing of writing to the output memory by an address calculation apparatus in a De-MIL apparatus according to Embodiment 8 of the present invention;

FIG.13 is a block diagram showing a configuration of a coding apparatus according to Embodiment 9 of the present invention;

FIG.14 is a block diagram showing a configuration of a decoding apparatus according to Embodiment 10 of the present invention;

FIG.15 is a block diagram showing a configuration of a mobile station apparatus according to Embodiment 11 of the present invention; and

FIG.16 is a block diagram showing a configuration of a base station apparatus according to Embodiment 12 of the present invention.

Best Mode for Carrying out the Invention

With reference now to the attached drawings, preferred embodiments of the present invention will be explained in detail below.

(Embodiment 1)

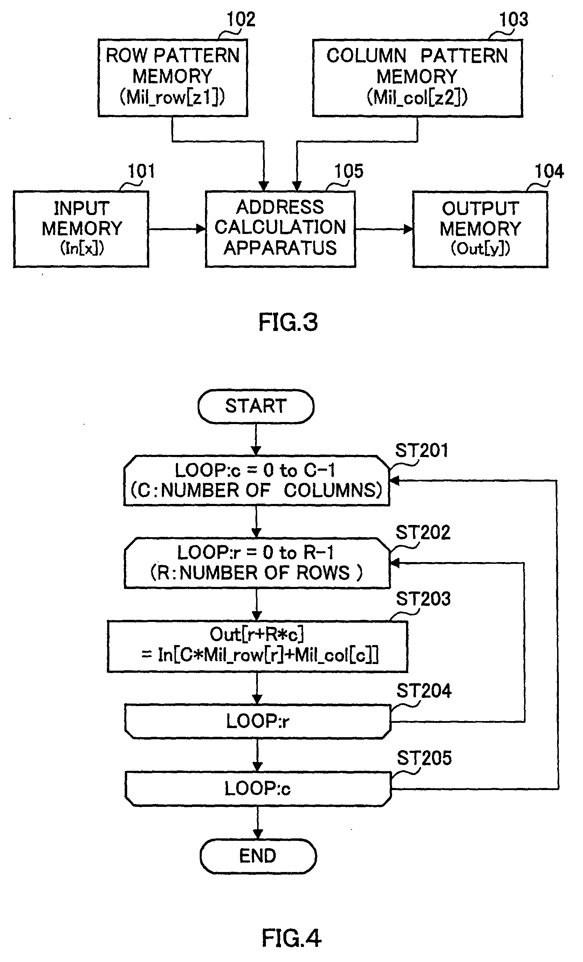

FIG.3 is block diagram showing a configuration of a MIL apparatus according to Embodiment 1 of the present invention. The MIL apparatus according to this embodiment is an apparatus that rearranges the sequence of data in a frame. This embodiment will be explained using 20[5[3×2]×4[2×2]shown in expression (1) as the MIL expression (sequence conversion rule expression) as an example.

In FIG.3, input memory 101 stores 20 input data items In[x] (x = 0 t 19). Here, the addresses of input data items are assumed to be {0,1,2, ..., 18,19}.

Row pattern memory 102 stores a MIL pattern (sequence conversion series) created from the MIL expression (5[3×2]) of stage 1 in expression (1), that is, row pattern Mil_row[r] shown in the following expression:

$$Mil\_row[r](r=0 \text{ to } 4)=\{0,2,4,1,3\} \qquad \text{-(3)}$$

Column pattern memory 103 stores a MIL pattern (sequence conversion series) created from the MIL expression (4[2x2]) of stage 1 in expression (1), that is, column pattern Mil_col[c] shown in the following expression:

$$Mil\_col[c](c=0 \text{ to } 3)=\{0,2,1,3\} \qquad \text{-(4)}$$

Output memory 104 stores 20 output data items Out[y] (y=0 to 19) with the sequence of input data rearranged.

Address calculation apparatus 105 calculates the address of input data to be written to the output data and writes the input data read from input memory 101 based on the calculated input address to output memory 104 as the output data. Here, processing of writing to output memory 104 by address calculation apparatus 105 will be explained with reference to FIG.4. FIG.4 is a flow chart showing processing of writing to output memory 104 by address calculation apparatus 105 in the MIL apparatus according to Embodiment 1 of the present invention.

In step (hereinafter referred to as "ST") 201, supposing c=0 first, processing up to ST205, which will be described later, is repeated and the processing ends when c>C-1 is satisfied. Here, C is the number of columns (here 4).

In ST202, supposing r=0 first, processing up to ST204, which will be described later, is repeated and the process moves on to ST205 only when r>R-1 is satisfied. Here, R is the number of rows (here 5).

In ST203, the address of input data to be written to output data [r+R×c] is calculated as shown in the following expression:

$$Mil\_col[c]+Mil\_row[r] \times C \qquad \text{-(5)}$$

Furthermore, in input memory 101, the input data stored at the address calculated according to expression (5) is read and written to output memory 104 as output data [r+R×c].

In ST204, after 1 is added to the value of r, the process moves on to ST202. In ST205, after 1 is added to the value of c, the process moves on to ST201.

Through the writing processing above by address calculation apparatus 105, the input data stored in input memory 101 is written to output data [y] (0 to 19) in output memory 104 sequentially according to the addresses shown in expression (2). That is, for example, input data [0], input data [8] and input data [16] are written to output data [0], output data [1] and output data [2], respectively.

As shown above, when the MIL expression shown in expression (1) is used, it is possible to implement MIL processing only with memory of a total of 9 words (except input/output memory) ; 5 words for the row pattern memory and 4 words for the column pattern memory. The output data written to output memory 104, that is, the input data whose sequence has been rearranged by MIL processing is then subjected to predetermined CDMA-based processing and sent.

As shown above, this embodiment stores a pattern developed from a MIL expression of stage 1 included in the MIL expression to be used, calculates the address of input data to be written for each output data item using the stored pattern and writes the input data stored at the calculated address to the output data sequentially, and therefore can implement MIL processing with a small amount of memory.

Furthermore, this embodiment describes the case where immediately after the address of input data to be written for each output data item is calculated, the input data items stored at the calculated addresses are written one by one to the output data, but the present invention is not limited to this, and the input data stored at the calculated addresses can also be read and written to the output data after the addresses of input data items to be written are calculated for all output data items.

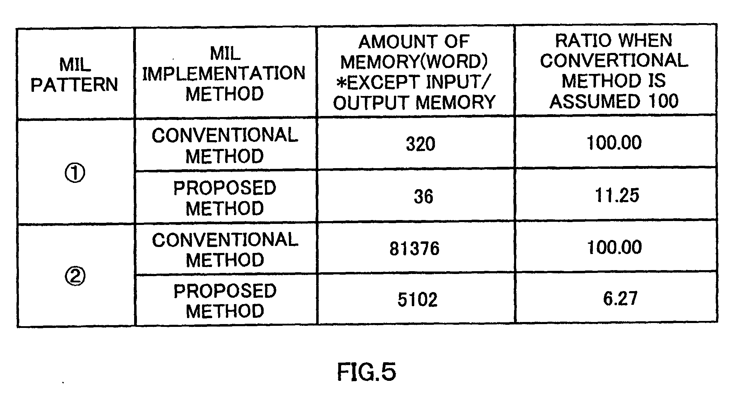

Here, the result of reduction of required memory of the MIL apparatus according to this embodiment will be explained with reference to FIG.5. FIG.5 shows the amount of memory required of the MIL apparatus according to Embodiment 1 of the present invention in comparison with the conventional system. FIG.5 shows the amounts of memory required when the following two MIL expressions are used:

①320[16[4[2x2]x4[2x2]]x20[4[2x2]x5[3x2]]]
②81376[5086[80[10[5[3x2]x2]x8[4[2x2]x2]]
x64[8[4[2x2]x2]x8[4[2x2]x2]])x16[4[2x2]x4[2x2]]

As is clear from FIG.5, this embodiment achieves a drastic reduction of the amount of memory required compared to the conventional system. Furthermore, the effect grows as the amount of data to be subjected to MIL processing increases.

This embodiment describes the case where expression (1) is used as the MIL expression, but the present invention is also applicable to a case where a MIL expression of deeper stage is used. For example, when expression ①shown in FIG.5 is used as a MIL expression, row pattern memory 102 stores a row pattern created from MIL expression of stage 2(16[4[2x2]x4[2x2]]) in expression ①and column pattern memory 103 stores a column pattern created from MIL expression of stage 2 (20[4[2x2]x5[3x2]])in expression ①and address calculation apparatus 105 calculates as described above using the patterns above.

(Embodiment 2)

Embodiment 2 implements MIL processing by calculating the address of output data to be written for each input data item and writing each input data item at the address calculated in the output memory in Embodiment 1.

What this embodiment differs from Embodiment 1 is processing of writing to output memory 104 by the address calculation apparatus. Furthermore, this embodiment differs from Embodiment 1 in row patterns stored in row pattern memory 102 and column patterns stored in column pattern memory 103. The components of this embodiment with the same configuration as that of Embodiment 1 will be explained with the same reference numerals as those in Embodiment 1 assigned. In this embodiment, as in the case of Embodiment 1, the MIL expression shown in expression (1) will be used.

First, row pattern memory 102 stores row pattern Mil_row[r] shown in the following expression created from MIL expression (5[2×3]).

$$\text{Mil\_row}[r](r=0 \text{ to } 4)=\{0,3,1,4,2\} \qquad -(6)$$

Furthermore, column pattern memory 103 stores Mil_col[c] shown in the following expression created from MIL expression (4[2×2]).

$$\text{Mil\_col}[c](c=0 \text{ to } 3)=\{0,2,1,3\} \qquad -(7)$$

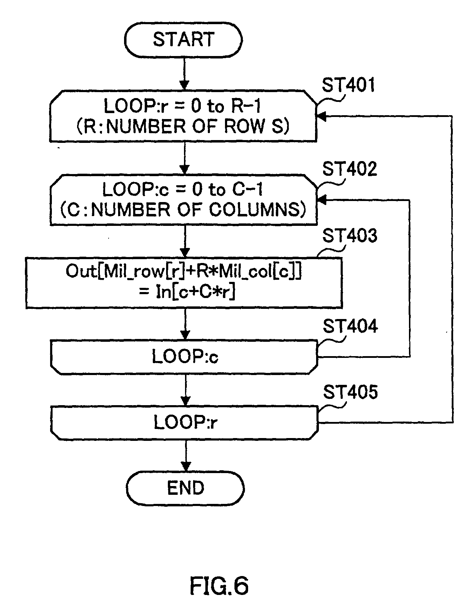

Furthermore, the address calculation apparatus calculates the addresses of output data items to be written for the input data items and writes the input data items at the addresses calculated in output memory 104. Here, processing of writing to output memory 104 by the address calculation apparatus will be explained with reference to FIG.6. FIG.6 is a flow chart showing processing of writing to output memory 104 by the address calculation apparatus of the MIL apparatus according to Embodiment 2 of the present invention.

In ST401, supposing r=0 first, processing up to ST405, which will be described later, is repeated and the process ends when r>R-1 is satisfied. Here, R is the number of rows (here 5).

In ST402, supposing c=0 first, processing up to ST404, which will be described later, is repeated and the process moves on to ST405 only when c>C-1 is satisfied. Here, C is the number of columns (here 4).

In ST403, the address of output data to which input data [c+C×r] is to be written is calculated as shown in the following expression:

$$\text{Mil\_row}[r]+\text{Mil\_col}[c]\times R \qquad -(8)$$

Furthermore, input data [c+C×r] is written at the address calculated according to expression (8) in output memory 104.

In ST404, after 1 is added to the value of c, the process moves on to ST402. In ST405, after 1 is added to the value of r, the process moves on to ST401.

Through the writing processing above by the address calculation apparatus, the input data items stored in input memory 101 are written at the addresses in output memory 104 calculated according to expression (8) sequentially.

As shown above, when the MIL expression shown in expression (1) is used, it is possible to implement MIL processing only with memory of a total of 9 words (except input/output memory) ; 5 words for the row pattern memory and 4 words for the column pattern memory.

As shown above, this embodiment stores a pattern developed from a MIL expression of stage 1 included in the MIL expression to be used, calculates the address of output memory to be written for each input data item using the stored pattern and writes the input data at the calculated address, and therefore can implement MIL processing with a small amount of memory.

(Embodiment 3)

Embodiment 3 implements MIL processing by writing data to output memory using addresses calculated using only column patterns in the case where the sequence of data is rearranged between frames, that is, when the column pattern is a simple incremental value in Embodiment 1.

In a CDMA communication, data may be rearranged not only in a frame but also between frames. This is referred to as "inter-frame interleave (inter-frame NIL)". The MIL expression used for inter-frame interleave is normally expressed in a form of $L[M_1 \times N_1[M_2 \times N_2]]$ and in this MIL expression, only column pattern expression ($N_1[M_2 \times N_2]$) exists. The MIL apparatus according to this embodiment will be explained below.

What this embodiment differs from Embodiment 1 is processing of writing to output memory 104 by the address calculation apparatus first. Furthermore, in this embodiment, row pattern memory 102 in Embodiment 1 is excluded. In this embodiment, only differences from Embodiment 1 will be explained below. The components of this embodiment with the same configuration as that of Embodiment 1 will be explained with the same reference numerals assigned. In this embodiment, the MIL expression shown below will be used.

$$80[20 \times 4[2 \times 2]] \qquad \qquad \text{-(9)}$$

First, column pattern memory 103 stores column pattern Mil_col[c] shown in the following expression created from MIL expression ($4[2 \times 2]$) of stage 1 in expression (9).

$$\text{Mil\_col}[c](c=0 \text{ to } 3)=\{0,2,1,3\} \qquad \qquad \text{-(10)}$$

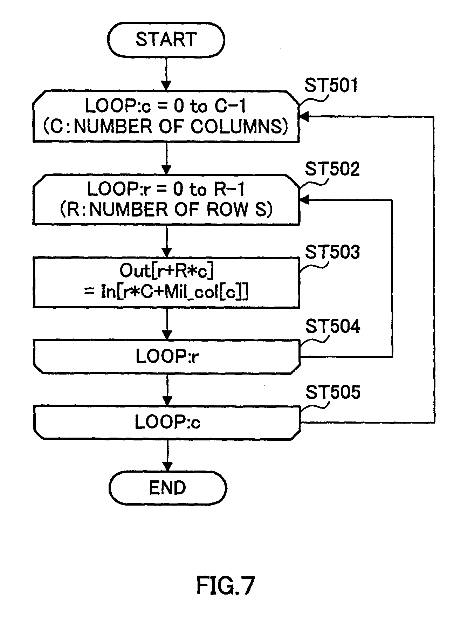

Furthermore, the address calculation apparatus calculates the addresses of input data to be written to the output data and writes the input data read from input memory 101 based on the calculated input addresses to output memory 104 as output data. Here, processing of writing to output memory 104 by the address calculation apparatus will be explained with reference to FIG.7. FIG.7 is a flow chart showing processing of writing to output memory 104 by the address calculation apparatus of the MIL apparatus according to Embodiment 3 of the present invention.

In ST501, supposing c=0 first, processing up to ST505, which will be described later, is repeated and the process ends when c>C-1 is satisfied. Here, C is the number of columns (here 4).

In ST502, supposing r=0 first, processing up to ST504, which will be described later, is repeated and the process moves on to ST505 only when r>R-1 is satisfied. Here, R is the number of rows (here 20).

In ST503, the address of input data to be written to output data [r+R×c] is calculated as shown in the following expression:

$$r \times C + \text{Mil\_col}[c] \qquad \qquad \text{-(11)}$$

Furthermore, the input data stored at the address calculated according to expression (11) in input memory 101 is read and written in output memory 104 as output data [r+R×c].

In ST504, after 1 is added to the value of r, the process moves on to ST502. In ST505, after 1 is added to the value of c, the process moves on to ST501.

Inter-frame interleave can be implemented by Embodiment 1 or Embodiment 2 above. However, since the MIL expression shown in expression (9) includes an increment value, it is necessary to store simple increment data in row pattern memory 102 when Embodiment 1 or Embodiment 2 is used. Therefore, when inter-frame interleave is performed, it is more efficient to use a MIL apparatus without row pattern memory as in this embodiment.

Here, the following is a comparison between the conventional system and Embodiments 1 to 3 with respect to an amount of memory required to implement inter-frame interleave using the MIL expression shown in expression (9):

①Conventional system: 80 words
②Embodiment 1 and Embodiment 2: 24 words
③Embodiment 3: 4 words

In the case of the MIL apparatus according to Embodiment 3, the amount of memory required is 1/20 of that in the conventional system and 1/6 in Embodiment 1 and Embodiment 2. Thus, with respect to inter-frame interleave, the MIL apparatus according to this embodiment is extremely effective.

Thus, when inter-frame interleave is performed, this embodiment stores only column patterns developed from a MIL expression of stage 1 included in the MIL expression to be used, further calculates the addresses of input data items to be written for output data items and writes input data items stored at the calculated addresses sequentially, and therefore can implement MIL processing with a small amount of memory.

(Embodiment 4)

Embodiment 4 implements MIL processing by calculating addresses of output data to be written for input data and writing the input data at the calculated addresses in the output memory when the sequence of data is rearranged between frames, that is, when a column pattern is a simple incremental value in Embodiment 2.

What this embodiment differs from Embodiment 2 is processing of writing to output memory 104 by the address calculation apparatus. Furthermore, row pattern memory 102 in Embodiment 2 is excluded in this embodiment. In this embodiment, only differences from Embodiment 1 will be explained. The components of this embodiment with the same configuration as that of Embodiment 1 will be explained with the same reference numerals assigned. In this embodiment, as in the case of Embodiment 3, the MIL expression shown in expression (9) will be used.

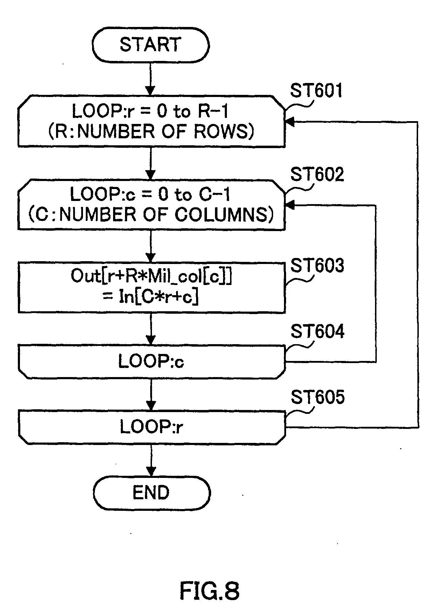

First, column pattern memory 103 stores column pattern Mil_col[c] shown in expression (10) as in the case of Embodiment 3. Furthermore, the address calculation apparatus calculates the addresses of output data to be written for the input data and writes the input data at the calculated addresses in output memory 104. Here, processing of writing to output memory 104 by the address calculation apparatus will be explained with reference to FIG.8. FIG.8 is a flow chart showing processing of writing to output memory 104 by the address calculation apparatus of the MIL apparatus according to Embodiment 4 of the present invention.

In ST601, supposing r=0 first, processing up to ST605, which will be described later, is repeated and the process ends when r>R-1 is satisfied. Here, R is the number of rows (here 20).

In ST602, supposing c=0 first, processing up to ST604, which will be described later, is repeated and the process moves on to ST605 only when C>C-1 is satisfied. Here, C is the number of rows (here 4).

In ST603, the address of output data to which input data [c+C×r] is to be written is calculated as shown in the following expression:

$$r \times R + \text{Mil\_col}[c] \qquad \qquad \text{-(12)}$$

Furthermore, input data [c+C×r] is written at the addresses calculated according to expression (12) in output memory 104.

In ST604, after 1 is added to the value of c, the process moves on to ST602. In ST605, after 1 is added to the value of r, the process moves on to ST601.

Thus, when inter-frame interleave is performed, this embodiment stores only column patterns developed from a MIL expression of stage 1 included in the MIL expression to be used, further calculates the addresses of output data to be written for input data and writes input data at the calculated addresses, and therefore can implement MIL processing with a small amount of memory.

(Embodiment 5)

Embodiment 5 implements a De-MIL (De-Multistage InterLeave) apparatus that restores the original sequence of data whose sequence has been rearranged by MIL processing. The De-MIL apparatus according to this embodiment can be implemented with the same configuration as that of Embodiment 1 (FIG.3). Hereinafter only differences of the De-MIL apparatus according to this embodiment from Embodiment 1 will be explained with reference to FIG.3. In this embodiment, a case where the original sequence of data whose sequence has been rearranged according to the MIL expression shown in expression (1) is restored will be explained as an example.

In FIG.3, input memory 101 stores 20 input data items In[x] (x=0 to 19) whose sequence has been rearranged. Row pattern memory 102 stores the row pattern shown in expression (6). Column pattern memory 103 stores the column pattern shown in expression (7). Output memory 104 stores 20 output data items Out[y] (y=0 to 19) with the original sequence of input data restored.

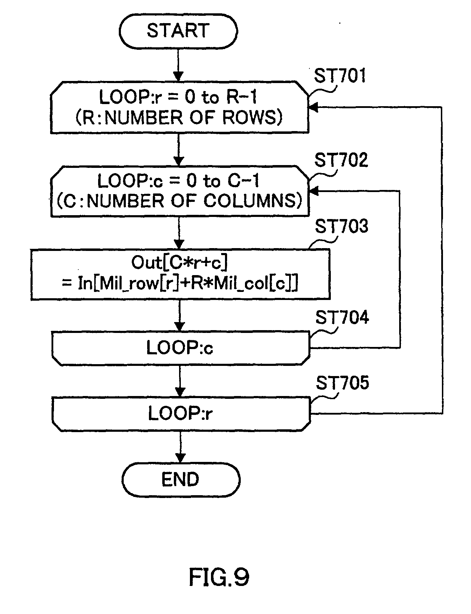

Address calculation apparatus 105 calculates the address of input data to be written to the output data and writes the input data read from input memory 101 based on the calculated input address to output memory 104 as the output data. Here, processing of writing to output memory 104 by address calculation apparatus 105 will be explained with reference to FIG.9. FIG. 9 is a flow chart showing processing of writing to output memory 104 by address calculation apparatus 105 in the De-MIL apparatus according to Embodiment 5 of the present invention.

In ST701, supposing r=0 first, processing up to ST705, which will be described later, is repeated and the processing ends when r>R-1 is satisfied. Here, R is the number of rows (here 5).

In ST702, supposing c=0 first, processing up to ST704, which will be described later, is repeated and the process moves on to ST705 only when c>C-1 is satisfied. Here, C is the number of columns (here 4).

In ST703, the address of input data to be written to output data [C×r+c] is calculated as shown in the following expression:

$$\text{Mil\_row}[r]+R\times\text{Mil\_col}[c] \qquad\qquad -(13)$$

Furthermore, in input memory 101, the input data stored at the address calculated according to expression (13) is read and written to output memory 104 as output data [C×r+c].

In ST704, after 1 is added to the value of c, the process moves on to ST702. In ST705, after 1 is added to the value of r, the process moves on to ST701.

As shown above, this embodiment stores a pattern developed from a MIL expression of stage 1 included in the MIL expression to be used, calculates the address of input data to be written for each output data item using the stored pattern and writes the input data stored at the calculated addresses to the output data sequentially, and therefore can implement De-MIL processing with a small amount of memory.

(Embodiment 6)

Embodiment 6 implements De-MIL processing by calculating addresses of output data to be written to input data in Embodiment 5 and writing the input data at the calculated addresses in the output memory.

What this embodiment differs from Embodiment 5 is processing of writing to output memory 104 by the address calculation apparatus. Furthermore, this embodiment differs from Embodiment 5 in row patterns stored in row pattern memory 102 and column patterns stored in column pattern memory 103. The components of this embodiment with the same configuration as that of Embodiment 5 will be explained with the same reference numerals assigned. In this embodiment, as in the case of Embodiment 5, the case where the original sequence of data whose sequence has been rearranged according to the MIL expression shown in expression (1) is restored will be explained as an example.

First, row pattern memory 102 stores row pattern Mil_row[r] shown in expression (3) and column pattern memory 103 stores column pattern Mil_col[c] shown in expression (4).

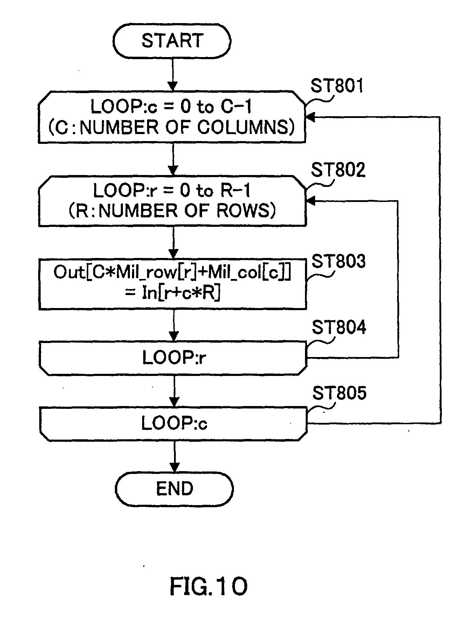

Furthermore, the address calculation apparatus calculates the addresses of output data to be written for the input data and writes the input data at the calculated addresses in output memory 104. Here, processing of writing to output memory 104 by the address calculation apparatus will be explained with reference to FIG.10. FIG.10 is a flow chart showing processing of writing to output memory 104 by the address calculation apparatus of the De-MIL apparatus according to Embodiment 6 of the present invention.

In ST801, supposing c=0 first, processing up to ST805, which will be described later, is repeated and the process ends when c>C-1 is satisfied. Here, C is the number of columns (here 4).

In ST802, supposing r=0 first, processing up to ST804, which will be described later, is repeated and the process moves on to ST805 only when r>R-1 is satisfied. Here, R is the number of rows (here 5).

In ST803, the address of output data to which input data [r+c×R] is to be written is calculated as shown in the following expression:

$$C\times\text{Mil\_row}[r]+\text{Mil\_col}[c] \qquad\qquad -(14)$$

Furthermore, input data [r+c×R] is written at the address calculated according to expression (14) in output memory 104.

In ST804, after 1 is added to the value of r, the process moves on to ST802. In ST805, after 1 is added to the value of c, the process moves on to ST801.

As shown above, this embodiment stores a pattern developed from a MIL expression of stage 1 included in the MIL expression to be used, calculates the address of output memory to be written for each input data item using the stored pattern and writes the input data at the calculated address, and therefore can implement De-MIL processing with a small amount of memory.

(Embodiment 7)

Embodiment 7 implements De-MIL processing by writing data in output memory using addresses calculated using only a column pattern when the original sequence of data is restored between frames in Embodiment 5, that is, when a column pattern is a simple incremental value.

What this embodiment differs from Embodiment 5 first is processing of writing to output memory by the address calculation apparatus. Furthermore, in this embodiment, row pattern memory 102 in Embodiment 5 is excluded. In this embodiment, only differences from Embodiment 5 will be explained below. The components of this embodiment with the same configuration as that of Embodiment 5 will be explained with the same reference numerals assigned. In this embodiment, the case where the original sequence of data whose sequence has been rearranged according to the MIL expression shown in expression (9) is restored will be explained as an example.

First, column pattern memory 103 stores column pattern Mil_col[c] shown in expression (10) created from MIL expression (4[2×2]) of stage 1 in expression (9).

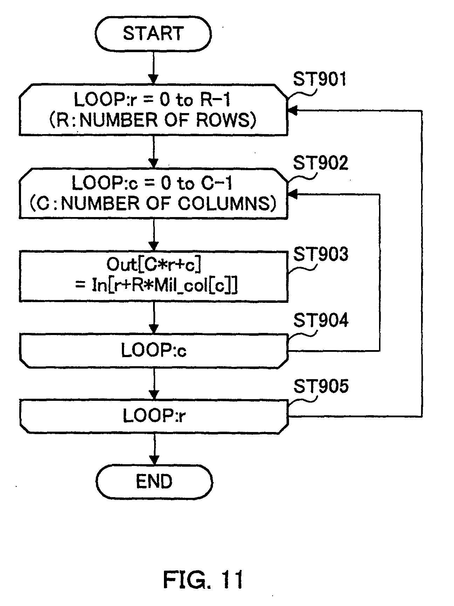

Furthermore, the address calculation apparatus calculates addresses of input data to be written to output data and writes the input data read from input memory 101 based on the calculated input addresses to output memory 104 as output data. Here, processing of writing to output memory 104 by the address calculation apparatus will be explained with reference to FIG.11. FIG.11 is a flow chart showing processing of writing to output memory 104 by the address calculation apparatus of the De-MIL apparatus according to Embodiment 7 of the present invention.

In ST901, supposing r=0 first, processing up to ST905, which will be described later, is repeated and the process ends when r>R-1 is satisfied. Here, R is the number of rows (here 20).

In ST902, supposing c=0 first, processing up to ST904, which will be described later, is repeated and the process moves on to ST905 only when c>C-1 is satisfied. Here, C is the number of columns (here 4).

In ST903, the address of input data to be written to output data [C×r+c] is calculated as shown in the following expression:

$$R \times Mil\_col[c]+r \qquad\qquad -(15)$$

Furthermore, in input memory 101, input data stored at addresses calculated according to expression (15) is read and written in output memory 104 as output data [C×r+c].

In ST904, after 1 is added to the value of c, the process moves on to ST902. In ST905, after 1 is added to the value of r, the process moves on to ST901.

As shown above, when the original sequence of data is restored between frames, this embodiment only stores a column pattern developed from a MIL expression of stage 1 included in the MIL expression to be used, calculates addresses of input data to be written for each output data item using the stored pattern and writes the input data stored at the calculated addresses to the output data sequentially, and therefore can implement De-MIL processing with a small amount of memory.

(Embodiment 8)

Embodiment 8 implements De-MIL processing by calculating the addresses of output data to be written for each input data item using only a column pattern and writing each input data item at the calculated address in output memory when the original sequence of data is restored between frames in Embodiment 6, that is, when a column pattern is a simple incremental value.

What this embodiment differs from Embodiment 6 is processing of writing to output memory 104 by the address calculation apparatus. Furthermore, in this embodiment, row pattern memory 102 in Embodiment 6 is excluded. In this embodiment, only differences from Embodiment 6 will be explained below. The components of this embodiment with the same configuration as that of Embodiment 1 will be explained with the same reference numerals assigned. In this embodiment, the case where the original sequence of data whose sequence has been rearranged according to the MIL expression shown in expression (9) is restored will be explained as an example.

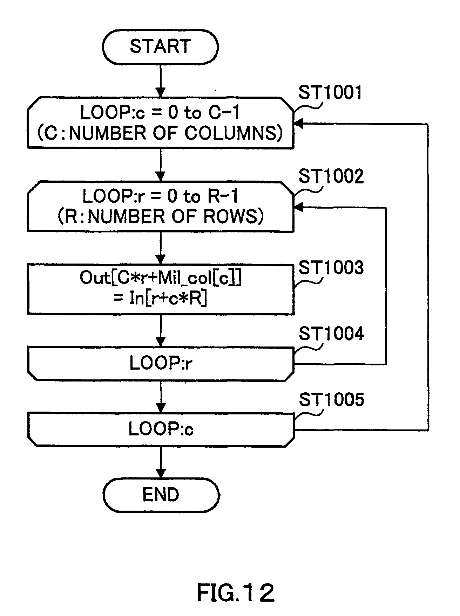

First, column pattern memory 103 stores column pattern Mil_col[c] shown in expression (10). Furthermore, the address calculation apparatus calculates the addresses of output data to be written for the input data and writes the input data at the addresses calculated in output memory 104. Here, processing of writing to output memory 104 by the address calculation apparatus will be explained with reference to FIG.12. FIG.12 is a flow chart showing processing of writing to output memory 104 by the address calculation apparatus of the De-MIL apparatus according to Embodiment 8 of the present invention.

In ST1001, supposing c=0 first, processing up to ST1005, which will be described later, is repeated and the process ends when c>C-1 is satisfied. Here, C is the number of columns (here 4).

In ST1002, supposing r=0 first, processing up to ST1004, which will be described later, is repeated and the process moves on to ST1005 only when r>R-1 is satisfied. Here, R is the number of rows (here 20).

In ST1003, the address of output data to which input data [r+c×R] is to be written is calculated as shown in the following expression:

$$r+R \times Mil\_col[c] \qquad\qquad -(16)$$

Furthermore, input data [r+c×R] is written at the address calculated according to expression (16) in output memory 104.

In ST1004, after 1 is added to the value of r, the process moves on to ST1002. In ST1005, after 1 is added to the value of c, the process moves on to ST1001.

As shown above, when the original sequence of data is restored between frames, this embodiment only stores a column pattern developed from a MIL expression of stage 1 included in the MIL expression to be used, calculates the address in output memory in which the data is to be written using the stored pattern and writes the input data at the calculated address, and therefore can implement De-MIL processing with a small amount of memory.

(Embodiment 9)

Embodiment 9 implements a coding apparatus comprising any one of the MIL apparatuses according to Embodiment 1 to Embodiment 4, or a MIL apparatus that combines Embodiment 1 to Embodiment 4, a transmission data coding apparatus and a transmission data length adjusting apparatus.

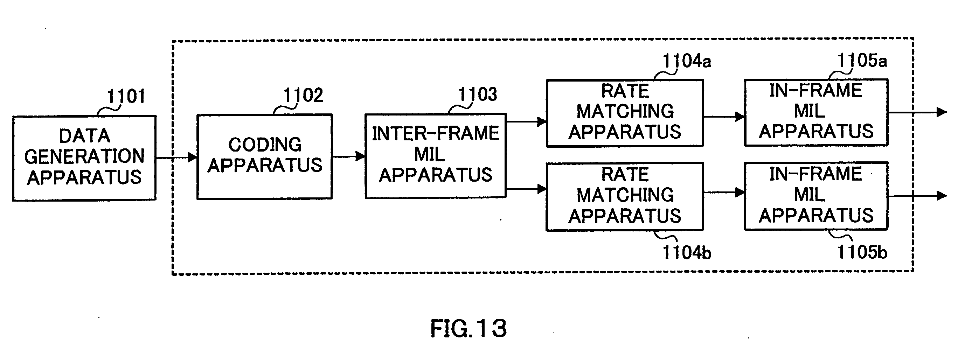

The coding apparatus according to this embodiment will be explained with reference to FIG.13. FIG.13 is a block diagram showing a configuration of the coding apparatus according to Embodiment 9 of the present invention. As shown in FIG.13, the coding apparatus according to this embodiment is mainly configured by data generation apparatus 1101 such as a microphone, coding apparatus 1102 that performs CRC coding and error correction coding, inter-frame MIL apparatus 1103 that performs MIL between frames, rate matching apparatus 1104a and rate matching apparatus 1104b that perform transmission data repetition/puncturing and in-frame MIL apparatus 1105a and in-frame MIL apparatus 1105b that perform MIL inside a frame.

Data generation apparatus 1101 generates data corresponding to a few frames (here 2 frames). Coding apparatus 1102 performs CRC coding and error correction coding on the 2-frame data generated.

Inter-frame MIL apparatus 1103 performs inter-frame MIL processing on the coded 2-frame data. As the inter-frame MIL apparatus, for example, the MIL apparatus according to Embodiment 3 or Embodiment 4 above can be used.

Rate matching apparatus 1104a and rate matching apparatus 1104b each perform repetition/puncturing processing on data of each frame subjected to inter-frame MIL processing.

In-frame MIL apparatus 1105a and in-frame MIL apparatus 1105b each perform in-frame MIL on data of each frame subjected to repetition/puncturing processing. As the in-frame MIL apparatus, for example, the MIL apparatus according to Embodiment 1 or Embodiment 2 above can be used.

As shown above, this embodiment can drastically reduce the amount of memory required for the inter-frame MIL apparatuses and in-frame MIL apparatuses, and therefore can significantly reduce the circuit scale of the coding apparatus.

(Embodiment 10)

Embodiment 10 implements a decoding apparatus comprising any one of the De-MIL apparatuses according to Embodiment 5 to Embodiment 8, or a De-MIL apparatus that combines Embodiment 5 to Embodiment 8, a reception data decoding apparatus and a reception data length adjusting apparatus.

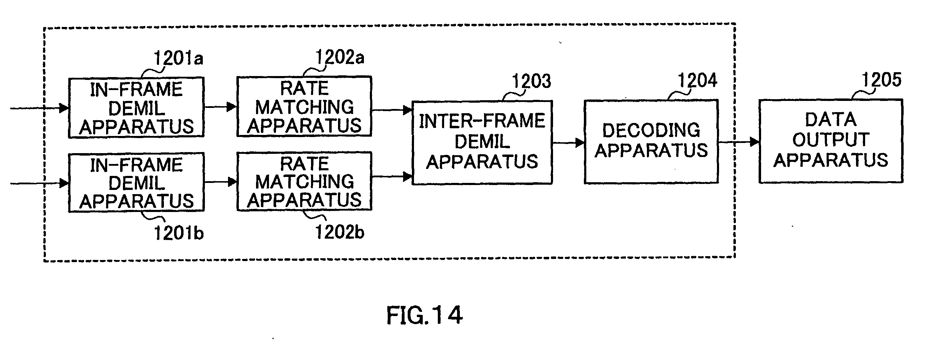

The decoding apparatus according to this embodiment will be explained with reference to FIG.14. FIG.14 is a block diagram showing a configuration of the decoding apparatus according to Embodiment 10. As shown in FIG.

14, the decoding apparatus according to this embodiment is mainly configured by in-frame De-MIL apparatus 1201a and De-MIL apparatus 1201b that perform De-MIL inside a frame, rate matching apparatus 1202a and rate matching apparatus 1202b that perform reception data repetition/puncturing, inter-frame De-MIL apparatus 1203 that performs De-MIL between frames, decoding apparatus 1204 that performs CRC decoding and error correction decoding and data output apparatus 1205.

In-frame De-MIL apparatus 1201a and in-frame De-MIL apparatus 1201b each perform in-frame De-MIL on reception data corresponding to a few frames (here 2 frames) . As the in-frame De-MIL apparatus, for example, the De-MIL apparatus according to Embodiment 5 or Embodiment 6 above can be used.

Rate matching apparatus 1202a and rate matching apparatus 1202b each perform rate matching processing on reception data subjected to De-MIL processing for each frame.

Inter-frame De-MIL apparatus 1203 performs inter-frame MIL processing on the 2-frame reception data subjected to rate matching processing. As the inter-frame De-MIL apparatus, for example, the De-MIL apparatus according to Embodiment 7 or Embodiment 8 above can be used.

Decoding apparatus 1204 performs error correction decoding and CRC decoding on the reception data subjected to inter-frame De-Mil processing. Data output apparatus 1205 performs output processing on the reception data subjected to error correction decoding and CRC decoding.

As shown above, this embodiment can drastically reduce the amount of memory required for the inter-frame De-MIL apparatuses and in-frame De-MIL apparatuses, and therefore can significantly reduce the circuit scale of the coding apparatus.

This embodiment describes the case where in-frame De-MIL processing, rate matching processing and inter-frame De-MIL processing are carried out sequentially as an example, but it is also possible to carry out in-frame De-MIL processing, inter-frame De-MIL processing and rate matching processing sequentially.

(Embodiment 11)

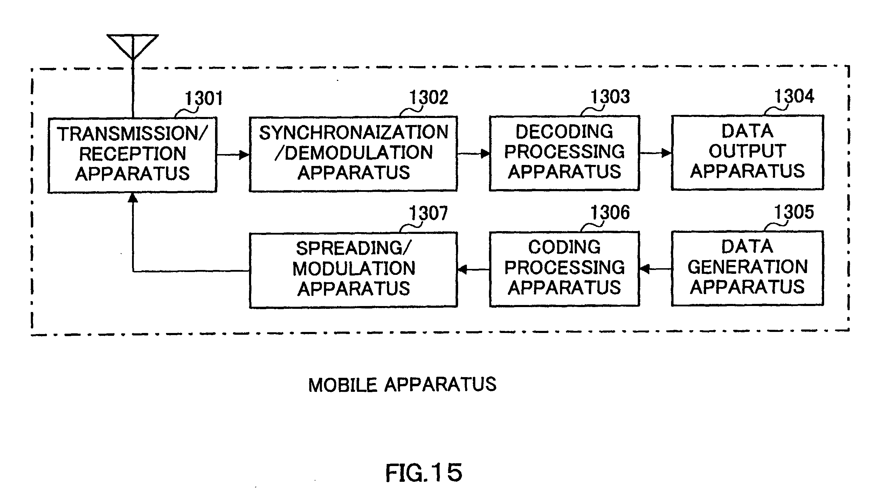

Embodiment 11 implements a mobile station apparatus using the coding apparatus in Embodiment 9 and decoding apparatus in Embodiment 10. The mobile station apparatus according to this embodiment will be explained with reference to FIG.15. FIG.15 is a block diagram showing a configuration of the mobile station apparatus according to Embodiment 11 of the present invention.

As shown in FIG.15, the mobile station apparatus according to this embodiment is mainly configured by transmission/reception apparatus 1301 that performs transmission/reception processing, synchronization/demodulation apparatus 1302 that performs synchronization and demodulation processing of reception data, decoding processing apparatus 1303 according to Embodiment 10 above, data output apparatus 1304 that outputs data, data generation apparatus 1305 that generates data or captures data such as voice from the outside, coding processing apparatus 1306 in Embodiment 9 above and spreading/modulation apparatus 1307 that performs spreading/modulation processing of transmission data.

This embodiment can drastically reduce the amount of memory required for inter-frame MIL, inter-frame De-MIL and in-frame MIL and in-frame De-MIL, and therefore can drastically reduce the circuit scale of the mobile station apparatus.

Furthermore, in the case where the in-frame MIL apparatus of Embodiment 1 (2) is used as the in-frame MIL apparatus in coding processing apparatus 1306 and the in-frame De-MIL apparatus of Embodiment 6 (5) is used as the in-frame De-MIL apparatus in decoding processing apparatus 1303, the in-frame MIL apparatus and in-frame De-MIL apparatus can use common row patterns and column patterns, making it possible to further reduce the circuit scale.

(Embodiment 12)

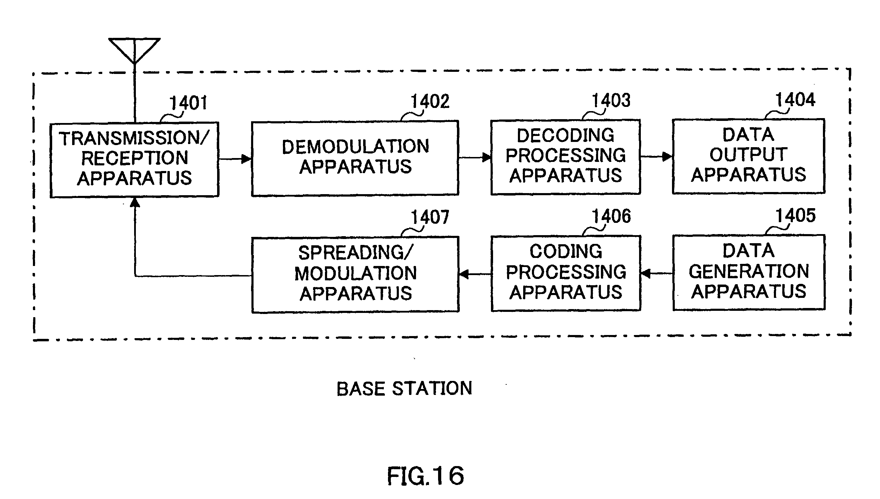

Embodiment 12 implements a base station apparatus using the coding apparatus in Embodiment 9 and decoding apparatus in Embodiment 10. The base station apparatus according to this embodiment will be explained with reference to FIG.16. FIG.16 is a block diagram showing a configuration of the base station apparatus according to Embodiment 12 of the present invention.

As shown in FIG.16, the base station apparatus according to this embodiment is mainly configured by transmission/reception apparatus 1401 that performs transmission/reception processing, demodulation apparatus 1402 that performs demodulation processing of reception data, decoding processing apparatus 1403 in Embodiment 10 above, data output apparatus 1404 that outputs data, data generation apparatus 1405 that generates data, coding processing apparatus 1406 in Embodiment 9 above and spreading/modulation apparatus 1407 that performs spreading/modulation processing of transmission data.

As shown above, this embodiment can drastically reduce the amount of memory required for inter-frame MIL, inter-frame De-MIL and in-frame MIL and in-frame De-MIL, and therefore can drastically reduce the circuit scale of the mobile station apparatus.

Furthermore, in the case where the in-frame MIL apparatus in Embodiment 1 (2) is used as the in-frame MIL apparatus in coding processing apparatus 1406 and the in-frame De-MIL apparatus in Embodiment 6 (5) is used as the in-frame De-MIL apparatus in decoding processing apparatus 1403, the in-frame MIL apparatus and in-frame De-MIL apparatus can use common row patterns and column patterns, making it possible to further reduce the circuit scale.

The above embodiment describes the case where at least one element of stage 1 of a MIL expression are used, but the present invention is also applicable to a case where at least one element of any stage are used.

The above embodiment describes the case where when the sequence of data is rearranged between frames, a column pattern developed from a MIL expression of stage 1 included in the MIL expression is used, but the present invention is also applicable to a case where a row pattern developed from a MIL expression of stage 1 included in the MIL expression is used.

Furthermore, the above embodiment describes the case where when the sequence of data is rearranged between frames, a MIL pattern developed from a MIL expression of stage 1 included in the MIL expression is used, but the present invention is also applicable to a case where when one MIL expression included in a MIL expression is lower than the other MIL expression in the MIL expression by at least one stage, the MIL pattern developed from the other MIL expression is used.

①The interleave apparatus according to the first embodiment of the present invention has a configuration comprising a conversion series creating section for creating at least one sequence conversion series using elements included in a sequence conversion rule expression specified for every input data item and a sequence changing section for changing the sequence of the input data using the created sequence conversion series.

This configuration makes it possible to create a sequence conversion series (MIL pattern) using elements in the sequence conversion rule (MIL expression), for example, a row pattern expression or column pattern expression created from each element of stage 1 and change the sequence of the input data using the created sequence conversion series, and therefore allows MIL processing to be performed with a reduced amount of memory required.

②The interleave apparatus according to the second embodiment of the present invention has a configuration with the sequence changing section of the first embodiment further comprising a first sequence calculating section for calculating the changed sequence of the input data and changing the sequence of the input data according to the calculated sequence.

This configuration ensures that the sequence of the input data is changed by calculating the sequence after the change of the sequence of the input data using the created sequence conversion series.

③The interleave apparatus according to the third embodiment of the present invention has a configuration with the sequence changing section of the first embodiment further comprising a second sequence calculating section for calculating the sequence of input data to be placed in this input data and changing the sequence of the input data according to the calculated sequence.

This configuration ensures that the sequence of the input data is changed by calculating the sequence of the input data to be placed in the input data after the change of the sequence using the created sequence conversion series.

④The interleave apparatus according to the fourth embodiment of the present invention has a configuration with the conversion series creating section of any one of the first embodiment to third embodiment creating a sequence conversion series, when one element included in the sequence conversion rule expression is lower than the other element by at least 1 stage, using the other element.

This configuration allows the amount of required memory to be further reduced by creating a sequence conversion series using only a column pattern expression when, for example, only the column pattern expression is included in the sequence conversion rule expression.

⑤The interleave apparatus according to the fifth embodiment of the present invention has a configuration with the sequence changing section of the first embodiment to fourth embodiment changing the sequence of input data whose sequence has been changed according the sequence conversion rule expression.

This configuration allows the original sequence of the input data whose sequence has been changed according to this sequence conversion rule expression to be restored by using the sequence conversion series created using the same sequence conversion rule expression.

⑥The communication terminal apparatus according to the sixth embodiment of the present invention comprises an interleave apparatus that has a configuration comprising a conversion series creating section for creating at least one sequence conversion series using elements included in a sequence conversion rule expression specified for every input data item and sequence changing section for changing the sequence of the input data using the created sequence conversion series.

This configuration provides a communication terminal apparatus with a reduced circuit scale by including an interleave apparatus that reduces required memory.

⑦The base station apparatus according to the seventh embodiment of the present invention comprises an interleave apparatus that has a configuration comprising a conversion series creating section for creating at least one sequence conversion series using elements included in a sequence conversion rule expression specified for every input data item and a sequence changing section for changing the sequence of the input data using the created sequence conversion series.

This configuration provides a base station apparatus with a reduced circuit scale by including an interleave apparatus that reduces required memory.

⑧The radio communication system according to the eighth embodiment of the present invention performs communications between a communication terminal apparatus equipped with an interleave apparatus and a base station apparatus equipped with the interleave apparatus above that has a configuration comprising a conversion series creating section for creating at least one sequence conversion series using elements included in a sequence conversion rule expression specified for every input data item and a sequence changing section for changing the sequence of the input data using the created sequence conversion series.

This configuration allows efficient radio communications to be implemented using the communication terminal apparatus and base station apparatus with a reduced circuit scale.

⑨The interleave method according to the ninth embodiment of the present invention comprises a conversion series creating step of creating at least one sequence conversion series using elements included in a sequence conversion rule expression specified for every input data item and a sequence changing step of changing the sequence of the input data using the created sequence conversion series.

This method makes it possible to create a sequence conversion series using elements in the sequence conversion rule, for example, a row pattern expression or column pattern expression created from each element of stage 1 and change the sequence of the input data using the created sequence conversion series, and therefore allows MIL processing to be performed with a reduced amount of memory required.

⑩ The interleave method according to the tenth embodiment of the present invention comprises a conversion series creating step of creating at least one sequence conversion series using elements included in a sequence conversion rule expression specified for every input data item and a sequence restoring step of restoring the sequence of the input data whose sequence has been changed according to the sequence conversion rule expression above using the created sequence conversion series.

This method allows the original sequence of input data whose sequence has been changed according to this sequence conversion rule expression to be restored by using the sequence conversion series created using the same sequence conversion rule expression.

As described above, the present invention creates at least one MIL pattern (sequence conversion series) using at least one element included in a MIL expression(sequence conversion rule expression) stipulated or specified for every input data item and changes the sequence of the input data using the created MIL pattern, and therefore can provide an interleave apparatus capable of reducing the amount of memory required.

This application is based on the Japanese Patent Application No.HEI 11-164055 filed on June 10, 1999, entire content of which is expressly incorporated by reference herein.

Industrial Applicability

The present invention is preferable to be used in a field of a coding/decoding processing apparatus and coding/decoding processing method in a CDMA mobile communication.

**Claims**

1. An interleave apparatus comprising:

    conversion series creating means for creating at least one sequence conversion series using at least one element included in a sequence conversion rule expression stipulated for every input data item; and
    sequence changing means for changing the sequence of the input data using the created sequence conversion series.

2. The interleave apparatus according to claim 1, wherein the sequence changing means further comprises a first sequence calculating means for calculating the sequence of the changed sequence of the input data and changes the sequence of the input data according to the calculated sequence.

3. The interleave apparatus according to claim 1 , wherein the sequence changing means further comprises a second sequence calculating means for calculating the sequence of the input data to be placed in this input data and changes the sequence of the input data according to the calculated sequence.

4. The interleave apparatus according to claim 1, wherein the conversion series creating means creates a sequence conversion series, when one element included in the sequence conversion rule expression is lower than the other element included in the expression by at least 1 stage, using the other element.

5. The interleave apparatus according to claim 1, wherein the sequence changing means changes the sequence of the input data whose sequence has been changed according to the sequence conversion rule expression.

6. A communication terminal apparatus equipped with an interleave apparatus, said interleave apparatus comprising:

   conversion series creating means for creating at least one sequence conversion series using at least one element included in a sequence conversion rule expression stipulated for every input data item; and
   sequence changing means for changing the sequence of the input data using the created sequence conversion series.

7. A base station apparatus equipped with an interleave apparatus, said interleave apparatus comprising:

   conversion series creating means for creating at least one sequence conversion series using at least one element included in a sequence conversion rule expression stipulated for every input data item; and
   sequence changing means for changing the sequence of the input data using the created sequence conversion series.

8. A radio communication system that performs communications between a communication terminal apparatus equipped with an interleave apparatus and a base station apparatus equipped with said interleave apparatus, said interleave apparatus comprising:

   conversion series creating means for creating at least one sequence conversion series using at least one element included in a sequence conversion rule expression stipulated for every input data item; and
   sequence changing means for changing the sequence of the input data using the created sequence conversion series.

9. An interleave method comprising:

   a conversion series creating step of creating at least one sequence conversion series using at least one element included in a sequence conversion rule expression stipulated for every input data item; and
   a sequence changing step of changing the sequence of the input data using the created sequence conversion series.

10. An interleave method comprising:

   a conversion series creating step of creating at least one sequence conversion series using at least one element included in a sequence conversion rule expression stipulated for every input data item; and
   a sequence restoring step of restoring the sequence of the input data whose sequence has been changed according to said sequence conversion rule expression using the created sequence conversion series.

MIL
PATTERN
(Mil[z])

14

INPUT
MEMORY
(In[x])

11

MEMORY
READING/WRITING
APPARATUS

12

OUTPUT
MEMORY
(Out[y])

13

FIG.1

START

LOOP:n = 0 to N-1
(N≦RxC)
(N:DATA COUNT)

ST11

Out[n] = In[Mil[n]]

ST12

LOOP:n

ST13

END

FIG.2

ROW PATTERN
MEMORY
(Mil_row[z1])

102

COLUMN PATTERN
MEMORY
(Mil_col[z2])

103

INPUT
MEMORY
(In[x])

101

ADDRESS
CALCULATION
APPARATUS

105

OUTPUT
MEMORY
(Out[y])

104

FIG.3

START

LOOP:c = 0 to C-1
(C:NUMBER OF COLUMNS)

ST201

LOOP:r = 0 to R-1
(R:NUMBER OF ROWS )

ST202

Out[r+R*c]
= In[C*Mil_row[r]+Mil_col[c]]

ST203

LOOP:r

ST204

LOOP:c

ST205

END

FIG.4

| MIL PATTERN | MIL IMPLEMENTATION METHOD | AMOUNT OF MEMORY(WORD) *EXCEPT INPUT/ OUTPUT MEMORY | RATIO WHEN CONVERTIONAL METHOD IS ASSUMED 100 |
|---|---|---|---|
| ① | CONVENTIONAL METHOD | 320 | 100.00 |
| | PROPOSED METHOD | 36 | 11.25 |
| ② | CONVENTIONAL METHOD | 81376 | 100.00 |
| | PROPOSED METHOD | 5102 | 6.27 |

FIG.5

EP 1 111 797 A1

START

LOOP:r = 0 to R-1
(R:NUMBER OF ROW S) ST401

LOOP:c = 0 to C-1
(C:NUMBER OF COLUMNS) ST402

Out[Mil_row[r]+R*Mil_col[c]]
= In[c+C*r] ST403

LOOP:c ST404

LOOP:r ST405

END

FIG.6

START

LOOP:c = 0 to C-1
(C:NUMBER OF COLUMNS) — ST501

LOOP:r = 0 to R-1
(R:NUMBER OF ROW S) — ST502

Out[r+R*c]
= In[r*C+Mil_col[c]] — ST503

LOOP:r — ST504

LOOP:c — ST505

END

FIG.7

START

LOOP:r = 0 to R−1
(R:NUMBER OF ROWS) — ST601

LOOP:c = 0 to C−1
(C:NUMBER OF COLUMNS) — ST602

Out[r+R*Mil_col[c]]
= In[C*r+c] — ST603

LOOP:c — ST604

LOOP:r — ST605

END

FIG.8

START

LOOP:r = 0 to R−1
(R:NUMBER OF ROWS) — ST701

LOOP:c = 0 to C−1
(C:NUMBER OF COLUMNS) — ST702

Out[C*r+c]
= In[Mil_row[r]+R*Mil_col[c]] — ST703

LOOP:c — ST704

LOOP:r — ST705

END

FIG.9

START

ST801
LOOP:c = 0 to C-1
(C:NUMBER OF COLUMNS)

ST802
LOOP:r = 0 to R-1
(R:NUMBER OF ROWS)

ST803
Out[C*Mil_row[r]+Mil_col[c]]
= In[r+c*R]

ST804
LOOP:r

ST805
LOOP:c

END

FIG.10

START

LOOP:r = 0 to R−1
(R:NUMBER OF ROWS) ST901

LOOP:c = 0 to C−1
(C:NUMBER OF COLUMNS) ST902

Out[C*r+c]
= In[r+R*Mil_col[c]] ST903

LOOP:c ST904

LOOP:r ST905

END

FIG. 11

START

LOOP:c = 0 to C-1
(C:NUMBER OF COLUMNS)     ST1001

LOOP:r = 0 to R-1
(R:NUMBER OF ROWS)     ST1002

Out[C*r+Mil_col[c]]
= In[r+c*R]     ST1003

LOOP:r     ST1004

LOOP:c     ST1005

END

FIG.12

```
┌──────────────┐      ┌──────────────┐      ┌──────────────┐      ┌──────────────┐      ┌──────────────┐
│     1101     │      │     1102     │      │     1103     │      │    1104a     │      │    1105a     │
│              │      │              │      │              │      │     RATE     │      │   IN-FRAME   │
│     DATA     │      │    CODING    │      │ INTER-FRAME  │      │   MATCHING   │      │     MIL      │──►
│  GENERATION  │─────►│  APPARATUS   │─────►│     MIL      │──┬──►│  APPARATUS   │─────►│  APPARATUS   │
│  APPARATUS   │      │              │      │  APPARATUS   │  │   └──────────────┘      └──────────────┘
└──────────────┘      └──────────────┘      └──────────────┘  │   ┌──────────────┐      ┌──────────────┐
                                                              │   │     RATE     │      │   IN-FRAME   │
                                                              └──►│   MATCHING   │─────►│     MIL      │──►
                                                                  │  APPARATUS   │      │  APPARATUS   │
                                                                  └──────────────┘      └──────────────┘
                                                                       1104b                 1105b
```

FIG.13

```
        1201a                 1202a
    ┌──────────┐         ┌──────────┐              1203              1204                  1205
    │ IN-FRAME │         │   RATE   │         ┌──────────┐     ┌──────────┐         ┌──────────┐
──▶ │  DEMIL   │ ──────▶ │ MATCHING │ ──────▶ │INTER-FRAME│     │ DECODING │         │   DATA   │
    │APPARATUS │         │APPARATUS │         │  DEMIL   │────▶│APPARATUS │ ──────▶ │  OUTPUT  │
    └──────────┘         └──────────┘         │APPARATUS │     │          │         │APPARATUS │
                                          ┌─▶ └──────────┘     └──────────┘         └──────────┘
    ┌──────────┐         ┌──────────┐     │
    │ IN-FRAME │         │   RATE   │     │
──▶ │  DEMIL   │ ──────▶ │ MATCHING │ ────┘
    │APPARATUS │         │APPARATUS │
    └──────────┘         └──────────┘
        1201b                 1202b
```

FIG.14

MOBILE APPARATUS

FIG.15

EP 1 111 797 A1

BASE STATION

FIG.16

## INTERNATIONAL SEARCH REPORT

| International application No. |
| --- |
| PCT/JP00/02604 |

A. CLASSIFICATION OF SUBJECT MATTER
    Int.Cl$^7$ H03M13/27

According to International Patent Classification (IPC) or to both national classification and IPC

B. FIELDS SEARCHED

Minimum documentation searched (classification system followed by classification symbols)
    Int.Cl$^7$ H03M13/27

Documentation searched other than minimum documentation to the extent that such documents are included in the fields searched
    Jitsuyo Shinan Koho(Y1,Y2)  1926-1996  Toroku Jitsuyo Shinan Koho(U) 1994-2000
    Kokai Jitsuyo Shinan Koho(U) 1971-2000  Jitsuyo Shinan Toroku Koho(Y2)1996-2000

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | WO, 99/25069, A1 (NTT Mobile Communications Network, Inc.), 20 May, 1999 (20.05.99), Figs. 41 to 44 & AU, 9915828, A | 1-10 |

☐ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 24 July, 2000 (24.07.00) | 08 August, 2000 (08.08.00) |

| Name and mailing address of the ISA/ | Authorized officer |
| --- | --- |
| Japanese Patent Office | |
| Facsimile No. | Telephone No. |

Form PCT/ISA/210 (second sheet) (July 1992)